(19) **Europäisches Patentamt / European Patent Office / Office européen des brevets**

(11) **EP 4 520 762 A1**

(12) **EUROPEAN PATENT APPLICATION**
published in accordance with Art. 153(4) EPC

(43) Date of publication:
**12.03.2025 Bulletin 2025/11**

(21) Application number: **23799531.1**

(22) Date of filing: **21.02.2023**

(51) International Patent Classification (IPC):
**C07F 7/28** (2006.01)

(52) Cooperative Patent Classification (CPC):
**C07F 7/28**

(86) International application number:
**PCT/KR2023/002470**

(87) International publication number:
**WO 2023/214648 (09.11.2023 Gazette 2023/45)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.05.2022 KR 20220054180**
**13.02.2023 KR 20230018726**

(71) Applicant: **Korea Atomic Energy Research Institute**
**Daejeon 34057 (KR)**

(72) Inventors:
- **KIM, Jong-Yun**
  **Daejeon 35247 (KR)**
- **NOH, Hye Ran**
  **Daejeon 34547 (KR)**
- **PARK, Junghwan**
  **Daejeon 34067 (KR)**
- **LIM, Sang Ho**
  **Daejeon 35397 (KR)**
- **KIM, Tae-Hyeong**
  **Daejeon 34127 (KR)**
- **LEE, Jeongmook**
  **Daejeon 34070 (KR)**

(74) Representative: **Gevers Patents**
**De Kleetlaan 7A**
**1831 Diegem (BE)**

(54) **ANDERSON-TYPE POLYOXOMETALATE AND PREPARATION METHOD THEREFOR**

(57) Provided is an Anderson-type polyoxometalate including titanium (Ti) as a heteroatom in the center of the Anderson-type polyoxometalate.

A method for preparing an Anderson-type polyoxometalate includes mixing a titanium precursor and a tungsten precursor to prepare a mixture, sealing the mixture in a container and heating to form a hydrothermal synthetic solution, and cooling the hydrothermal synthetic solution and then adding a solute to form an Anderson-type polyoxometalate.

FIG. 1

Ti/WO$_6$ octahedron     Six edge-sharing WO$_6$ octahedrons

⊘ Ti/W
◉ W
○ K
⊙ Na
● O

EP 4 520 762 A1

## Description

### [Technical Field]

The following disclosure relates to an Anderson-type polyoxometalate and a method for preparing the same.

### [Background Art]

A polyoxometalate (POM) is a metal oxide cluster formed of an early transition metal in a high oxidation number state, such as, for example, Mo, W, V, Nb, and Ta and oxygen. Since an oxygen atom abundant on the surface may donate an electron as an electron acceptor in the polyoxometalate, the polyoxometalate is regarded as a weak base (soft base). However, since a metal ion forming the skeleton of the polyoxometalate has an unfilled orbital, it is also regarded as a Lewis acid capable of accepting electrons. Accordingly, the polyoxometalate acts as a Lewis acid or a Lewis base depending on the conditions. In addition, the polyoxometalate is also known as an electron storage, since the polyoxometalate has unique redox properties which are an ability to hold strong electrons and an ability to release electrons. Furthermore, since the polyoxometalate not only has various structures and sizes but also allows artificial modeling which substitutes elements forming the polyoxometalate, the polyoxometalate is being applied in various fields such as catalyst, nanoscience, medicine, and optics.

Among the polyoxometalates, an Anderson-type polyoxometalate is represented by a general formula of $[H_y(XO_6)M_6O_{18}]^{n-}$ (y = 0-6, n = 2-8, M = addenda atom, X = heteroatom). In the Anderson-type polyoxometalate, a structure in which the heteroatom is present as $XO_6$ having an octahedral geometry at the center, and six $MO_6$ octahedrons around the heteroatom share edges is formed. Since the structure of the Anderson-type polyoxometalate is different from the structures of other types, for example, Keggin-type $[XM_{12}O_{40}]^{n-}$ or Dawson-type $[XM_{18}O_{62}]^{n-}$, the properties of the Anderson-type polyoxometalate are also different from the properties of other types of polyoxometalates.

In addition, the Anderson-type polyoxometalate has two terminal oxygen atoms in each addenda atom. Since the Anderson-type polyoxometalate has high reactivity and various coordination modes, it may bind to a hybrid material having various functions and be used as an ideal inorganic building block capable of modification.

The Anderson-type polyoxometalate may have properties which change depending on heteroatom change. The redox properties of the Anderson-type polyoxometalate are highly dependent on the heteroatom and pH, and various materials such as $CoMo_6$, $IrW_6$, $CrMo_6$, and $TeW_6$ are being researched in this regard. In addition, the magnetic properties of the Anderson-type polyoxometalate result from whether heteroatom symmetry exists in the polyoxometalate or not. Besides, according to the density functional theory (DFT), a HOMO-LUMO energy gap is determined by the heteroatom in the center of the polyoxometalate. Since the HOMO-LUMO energy gap as such has a significant influence on photocatalytic performance, a research in which photocatalytic performance is compared by changing the heteroatom in the center of the polyoxometalate is being actively conducted.

When the heteroatom is included in the polyoxometalate, a radius size of ions is an important factor, and the radius size of ions which has been successfully synthesized so far is about 67 to 88 pm in a $XMo_6$ system and about 67 to 83 pm in an $XW_6$ system. In terms of the radius size of ions, $Ti^{4+}$ (75 pm) sufficiently falls within the theoretically accessible range. In addition, since $Ti^{4+}$ has a very similar ion radius to $W^{6+}$ (74 pm) and also has the same most common coordination number of 6 as $W^{6+}$, titanium is known as an element which may replace polytungstate the best. Nevertheless, there has been no reported case of successful synthesis of the Anderson-type polyoxometalate including titanium as a heteroatom to date.

As a related literature, U.S. Patent Laid-Open Publication No. 2006-0108563 discloses "Luminescent compounds", U.S. Patent Laid-Open Publication No. 2019-0352320 discloses "Single-side modified beta-Anderson-type heteropolymolybdate organic derivatives", and Amir Blazevic et al. discloses "The Anderson-Evans polyoxometalate: From inorganic building blocks via hybrid organic-inorganic structures to tomorrows "Bio-POM" (Amir Blazevic, Annette Rompel, Coordination Chemistry Reviews 307 2016 42-64)".

### [Disclosure]

### [Technical Problem]

The present disclosure attempts to provide a new Anderson-type polyoxometalate including titanium as a central metal atom, and a method for preparing the same.

In addition to the above objects, an exemplary embodiment according to the present disclosure may be used for achieving other objects which are not specifically mentioned.

**[Technical Solution]**

An exemplary embodiment of the present disclosure provides an Anderson-type polyoxometalate including titanium (Ti) as a heteroatom in the center of the Anderson-type polyoxometalate.

An exemplary embodiment of the present disclosure provides an Anderson-type polyoxometalate represented by the following Chemical Formula 1:

[Chemical Formula 1]     $K_6Na_2Ti_{1-a}W_{6+a}O_{24}·12H_2O$ (0 < a < 0.2).

An exemplary embodiment of the present disclosure provides a method for preparing an Anderson-type polyoxometalate including: mixing a titanium precursor and a tungsten precursor to prepare a mixture; sealing the mixture in a container and heating to form a hydrothermal synthetic solution; cooling the hydrothermal synthetic solution and then adding a solute to form an Anderson-type polyoxometalate; and filtering the Anderson-type polyoxometalate.

An exemplary embodiment of the present disclosure provides a method for preparing an Anderson-type polyoxometalate according to an exemplary embodiment including: mixing titanium oxysulfate and sodium tungstate to prepare a mixture; sealing the mixture in a container and heating to form a hydrothermal synthetic solution; and cooling the hydrothermal synthetic solution and then adding potassium chloride to form an Anderson-type polyoxometalate; and filtering the Anderson-type polyoxometalate.

**[Advantageous Effects]**

It is known to those skilled in the art that among various transition metals such as Mo, W, V, Nb, and Ta, the synthesis of Anderson-type polyoxometalate material with Ti has not been successful yet. Accordingly, a new Anderson-type polyoxometalate including titanium as a metal atom at the center position according to an exemplary embodiment is a new material, and may be used in various fields such as catalyst, nanoscience, medicine, and optics.

**[Description of the Drawings]**

FIG. 1 is a drawing which schematically shows a $Ti/WO_6$ octahedron, six $WO_6$ octahedrons, and a $Ti/WO_6$ octahedron and six $WO_6$ octahedrons connected through edge-sharing, according to an exemplary embodiment.

FIG. 2 is a drawing which shows a framework of Anderson-type $K_6Na_2Ti_{0.92}W_{6.08}O_{24}·12H_2O$ according to an exemplary embodiment to an ab plane.

FIG. 3 is a drawing which shows a framework of Anderson-type $K_6Na_2Ti_{0.92}W_{6.08}O_{24}·12H_2O$ according to an exemplary embodiment to an ac plane.

FIG. 4 is a drawing which schematically shows a process of synthesizing Anderson-type $K_6Na_2Ti_{0.92}W_{6.08}O_{24}·12H_2O$ according to an exemplary embodiment.

FIG. 5 is a graph which shows results of P-XRD (Powder X-Ray Diffraction) pattern depending on a composition ratio of $TiOSO_4·xH_2SO_4·yH_2O$ and $Na_2WO_4·2H_2O$ for synthesizing Anderson-type $K_6Na_2Ti_{0.92}W_{6.08}O_{24}·12H_2O$ according to an exemplary embodiment.

FIG. 6 is a graph which shows powder XRD of Anderson-type $K_6Na_2Ti_{0.92}W_{6.08}O_{24}·12H_2O$ according to an exemplary embodiment.

FIG. 7 is a graph which shows comparison of powder XRD of Anderson-type $K_6Na_2Ti_{0.92}W_{6.08}O_{24}·12H_2O$ and conventional $KeNa_2PtW_6O_{24}·12H_2O$ according to an exemplary embodiment.

**[Mode for Invention]**

Exemplary embodiments of the present disclosure will be described in detail so that a person with ordinary skill in the art to which the present disclosure pertains may easily carry out the exemplary embodiments, with reference to the accompanying drawings. The present disclosure may be implemented in various different forms and is not limited to the exemplary embodiments described herein. In the drawings, parts which are not relevant to the description have been omitted for clearly describing the present disclosure, and the same reference numerals are used for same or similar components throughout the specification. In addition, for well-known technologies, the specific description thereof will be omitted.

Throughout the specification, when a part "comprises" any component, unless particularly described to the contrary, it will be understood to imply the further inclusion of other components but not the exclusion of other components.

Then, an Anderson-type polyoxometalate and a method for preparing the same according to an exemplary embodiment will be described in detail.

The Anderson-type polyoxometalate according to an exemplary embodiment includes titanium (Ti) as a heteroatom in the center of the Anderson-type polyoxometalate.

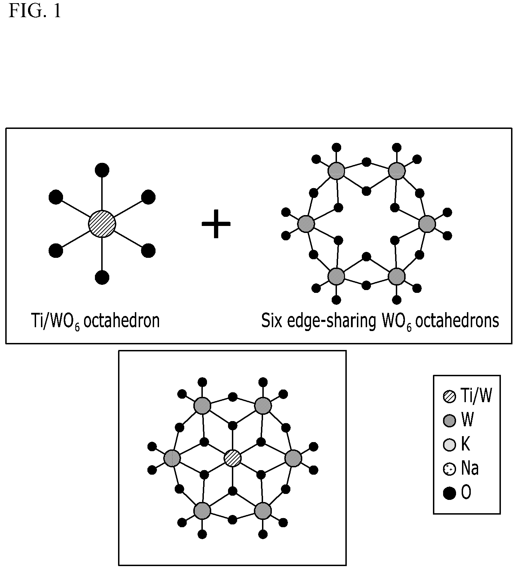

Referring to FIG. 1, in the Anderson-type polyoxometalate, the heteroatom positioned at the center is $Ti/WO_6$ having an octahedral geometry, and six $WO_6$ octahedrons have edge-sharing of oxygen atoms.

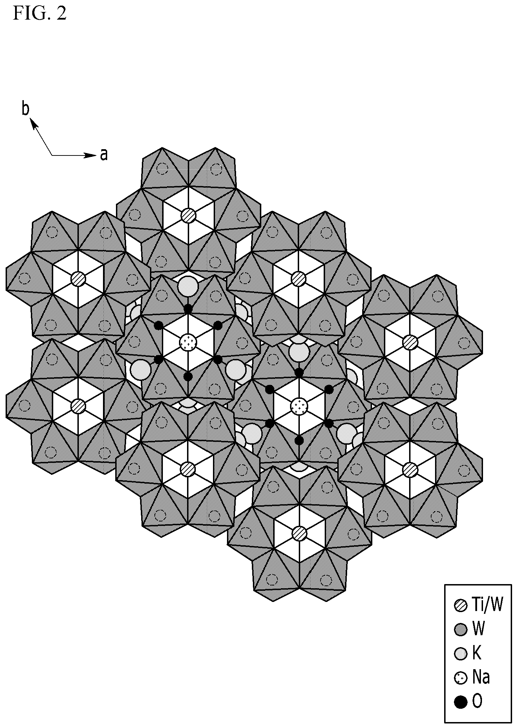

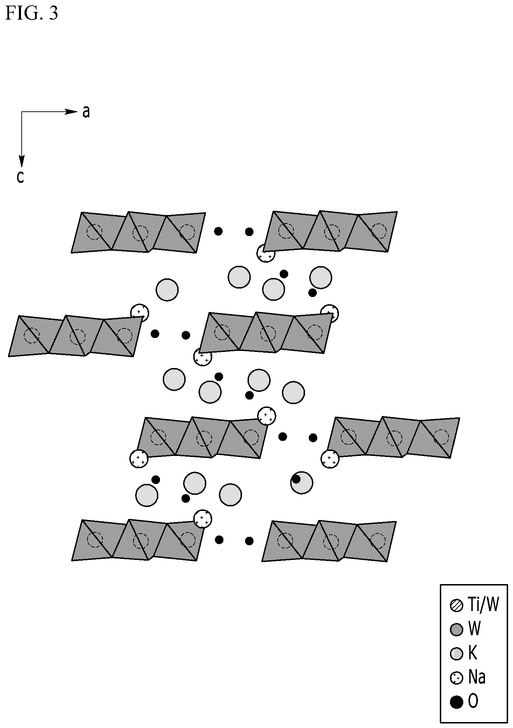

Referring to FIGS. 2 and 3, the structure of the Anderson-type polyoxometalate is planar on the whole and has a zero-dimensional framework.

The Anderson-type polyoxometalate has a rhombohedral structure with space group R-3m (No.166) and $D_{3d}$ symmetry.

The Anderson-type polyoxometalate includes titanium and tungsten, the titanium is derived from a titanium precursor, and the tungsten is derived from a tungsten precursor.

For example, the titanium precursor includes titanium oxysulfate, titanium disulfate, titanium chloride, titanium isopropoxide, and the like. The tungsten precursor includes tungstate. For example, the tungstate includes sodium tungstate, potassium tungstate, and the like.

A mixing molar ratio of the titanium precursor and the tungsten precursor may be 0.5:6 to 2.5:6. When the molar ratio is lower than 0.5:6, a synthesis reaction is possible, but compound phases having other crystal structures coexist, so that the synthesis yield of a pure Anderson-type polyoxometalate compound may drop significantly. When the molar ratio is higher than 2.5:6, other compound phases are produced, or powder is not formed.

The Anderson-type polyoxometalate according to an exemplary embodiment may be represented by the following Chemical Formula 1:

[Chemical Formula 1]     $K_6Na_2Ti_{1-a}W_{6+a}O_{24} \cdot 12H_2O$ (0 < a < 0.2).

In the hetero-site of the Anderson-type polyoxometalate, $Ti^{4+}$ and $W^{4+}$ show occupancy at a ratio of (1-a) to a.

The method for preparing an Anderson-type polyoxometalate according to an exemplary embodiment includes: mixing a titanium precursor and a tungstate precursor to prepare a mixture; sealing the mixture in a container and heating to form a hydrothermal synthetic solution; and cooling the hydrothermal synthetic solution and then adding a solute to form an Anderson-type polyoxometalate in a powder form.

The preparing of a mixture includes mixing a titanium precursor and a tungstate precursor.

For example, in the mixing of a titanium precursor and a tungstate precursor with water or acetonitrile to prepare a mixture, compounds described above may be used as the titanium precursor and the tungstate precursor.

For example, the titanium precursor includes titanium oxysulfate, titanium disulfate, titanium chloride, titanium isopropoxide, and the like. The tungsten precursor includes a tungstate. For example, the tungstate includes sodium tungstate, potassium tungstate, and the like.

In addition, a mixing molar ratio of the titanium precursor and the tungsten precursor may be 0.5:6 to 2.5:6. When the mixing molar ratio is lower than 0.5:6, a synthesis reaction is possible, but compound phases having other crystal structures coexist, so that a synthesis yield of a pure Anderson-type polyoxometalate compound may drop significantly. When the mixing molar ratio is higher than 2.5:6, other compound phases are produced, or powder is not formed.

The forming of a hydrothermal synthetic solution includes sealing the mixture described above in a container and then heating.

In the sealing of the mixture in the container and heating to form a hydrothermal synthetic solution, hydrothermal synthesis may be carried out at about 20°C to about 500°C for about 1 day to about 3 days. When the synthesis temperature is lower than 20°C and a synthesis period is less than 1 day, crystallinity may be greatly deteriorated and a synthesis yield may be significantly low. Even when the synthesis temperature is higher than 500°C and the synthesis period is less than 1 day, crystallinity may be greatly deteriorated and a synthesis yield may be significantly low

The forming of an Anderson-type polyoxometalate includes cooling and then filtering a hydrothermal synthetic solution. For example, by filtering the cooled hydrothermal synthetic solution, by-products may be removed from the cooled hydrothermal synthetic solution and only a pure Anderson-type polyoxometalate solution may be collected.

The forming of an Anderson-type polyoxometalate includes adding a solute to the pure Anderson-type polyoxometalate solution to recover the Anderson-type polyoxometalate in a powder state.

For example, the solute which is added after cooling the pure Anderson-type polyoxometalate solution obtained by the hydrothermal synthesis includes potassium chloride, potassium nitrate, potassium sulfate, potassium carbonate, and the like which are precursors including potassium. In addition, the solute may be used at 0.8 mol to 1.2 mol compared with the tungsten precursor, and when the solute is used at less than 0.8 mol, the synthesis yield may decrease, and when the solute is used at more than 1.2 mol, the solute is separated and removed in a washing process, but reagents may be wasted.

In addition, after the solute is added, stirring may be performed for about 0.5 days to about 1.5 days, and when a stirring time is shorter than 0.5 days, unreacted substances may remain, so that the synthesis yield may decrease, and when the stirring time is longer than 1.5 days, a process time may be wasted unnecessarily.

The method for preparing an Anderson-type polyoxometalate according to an exemplary embodiment may include washing the formed Anderson-type polyoxometalate with a washing solution, carrying out centrifugation, and then drying to obtain Anderson-type polyoxometalate powder. For example, the washing solution includes basic solutions such as sodium hydroxide and potassium hydroxide.

The method for preparing an Anderson-type polyoxometalate according to an exemplary embodiment may include filtering the formed Anderson-type polyoxometalate to obtain an Anderson-type polyoxometalate single crystal.

Hereinafter, the present disclosure will be described in more detail with the examples, but the following examples only illustrate the present disclosure and the present disclosure is not limited to the following examples.

Example 1

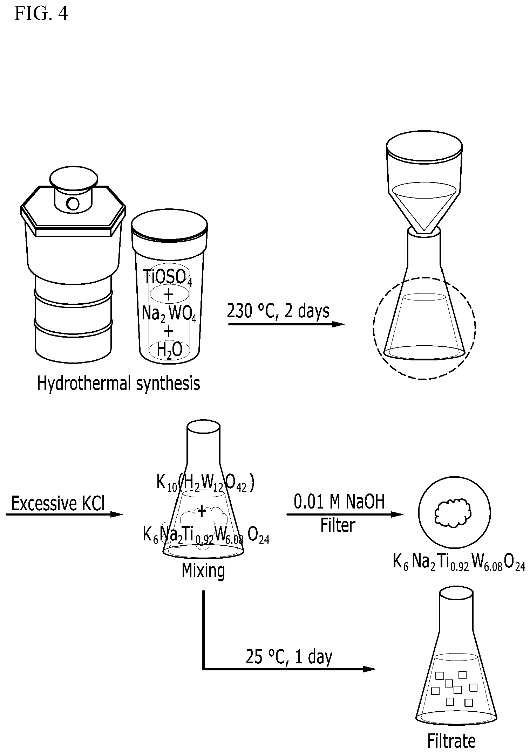

Referring to FIG. 4, Anderson-type $K_6Na_2Ti_{0.92}W_{6.08}O_{24} \cdot 12H_2O$ is synthesized using a hydrothermal reaction. $TiOSO_4 \cdot xH_2SO_4 \cdot yH_2O$ (0.1599 g, $5.79 \times 10^{-4}$ mol), $Na_2WO_4 \cdot 2H_2O$ (0.8814 g, $2.67 \times 10^{-3}$ mol), and 10 mL of deionized water are mixed, the mixture is added to a 23 mL Teflon cup, which is then placed in a stainless steel autoclave. Next, the autoclave is sealed, heated at 230°C for 2 days, and then cooled to room temperature. After the cooling, the autoclave is opened, filtration is performed to remove by-products, and a filtrate is collected. An excessive amount of KCl (2.5 g, $3.35 \times 10^{-2}$ mol) is added to the filtrate and stirring is performed for 1 day.

A product formed in a cloudy form is washed with a NaOH solution (0.01 M), centrifuged, and then dried to obtain $K_6Na_2Ti_{0.92}W_{6.08}O_{24} \cdot 12H_2O$ in a powder form. Additionally, in order to grow it into a single crystal, the product produced in a cloudy form is filtered before adding the NaOH solution, the filtrate is allowed to stand at room temperature to perform preparation.

Example 2

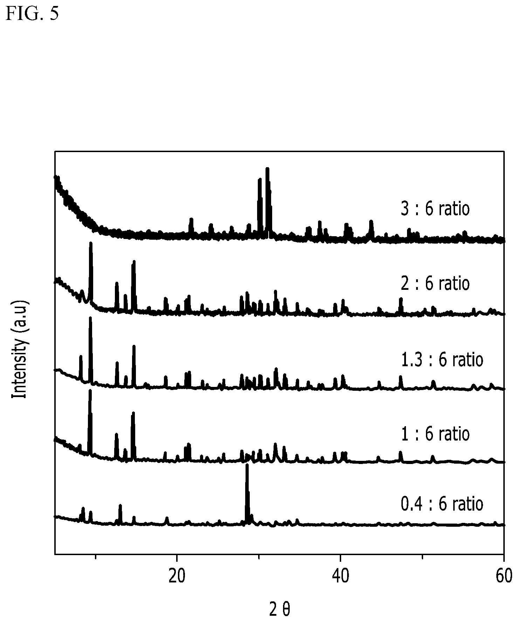

In order to confirm a range of compositions which may be synthesized, the experiment is carried out while changing a composition ratio. Experiment conditions are described in the following Table 1, and the experiment is carried out in the same manner as in Example 1 described above, except for the composition ratio. As synthesis results, whether the synthesis is successful or not is confirmed by powder XRD. Referring to FIG. 5, from the P-XRD results, synthesis is possible in a range of a ratio of $TiOSO_4 \cdot xH_2SO_4 \cdot yH_2O$ and $Na_2WO_4 \cdot 2H_2O$ from 1:6 to 2:6. However, when the amount of $TiOSO_4 \cdot xH_2SO_4 \cdot yH_2O$ increases, synthesis of other phases is confirmed. For example, when the ratio of $TiOSO_4 \cdot xH_2SO_4 \cdot yH_2O$ and $Na_2WO_4 \cdot 2H_2O$ is 3:6, powder is formed but synthesized in other phases, and when the ratio of $TiOSO_4 \cdot xH_2SO_4 \cdot yH_2O$ and $Na_2WO_4 \cdot 2H_2O$ is 1:1, the powder itself is not formed. In addition, when the amount of $TiOSO_4 \cdot xH_2SO_4 \cdot yH_2O$ decreases, the synthesis yield of a pure Anderson-type polyoxometalate decreases. For example, when the ratio of $TiOSO_4 \cdot xH_2SO_4 \cdot yH_2O$ and $Na_2WO_4 \cdot 2H_2O$ is 0.4:6, synthesis is possible, but compound phases having other crystal structures coexist, so that the synthesis yield of a pure $K_6Na_2Ti_{0.92}W_{6.08}O_{24} \cdot 12H_2O$ compound significantly decreases.

(Table 1)

| No. | $TiOSO_4 \cdot xH_2SO_4 \cdot yH_2O$ | $Na_2WO_4 \cdot 2H_2O$ | Ratio (Ti:W) | $H_2O$ | Synthesis results |
|---|---|---|---|---|---|
| 1 | 0.0492 g ($1.78 \times 10^{-4}$ mol) | 0.8814 g ($2.67 \times 10^{-3}$ mol) | 0.4:6 | 10 mL | ○ |
| 2 | 0.1229 g ($4.45 \times 10^{-4}$ mol) | 0.8814 g ($2.67 \times 10^{-3}$ mol) | 1:6 | 10 mL | ○ |
| 3 | 0.1599 g ($5.79 \times 10^{-4}$ mol) | 0.8814 g ($2.67 \times 10^{-3}$ mol) | 1.3:6 | 10 mL | ○ |
| 4 | 0.2458 g ($8.90 \times 10^{-4}$ mol) | 0.8814 g ($2.67 \times 10^{-3}$ mol) | 2:6 | 10 mL | ○ |
| 5 | 0.3687 g ($1.34 \times 10^{-3}$ mol) | 0.8814 g ($2.67 \times 10^{-3}$ mol) | 3:6 | 10 mL | × |
| 6 | 0.1229 g ($4.45 \times 10^{-4}$ mol) | 0.1469 g ($4.45 \times 10^{-4}$ mol) | 1:1 | 10 mL | × |

Referring to FIGS. 1 to 3, $K_6Na_2Ti_{0.92}W_{6.08}O_{24} \cdot 12H_2O$ has a Rhombohedral structure with space group R-3m (No. 166) and $D_{3d}$ symmetry. Upon review of the crystal structure in detail, there is a heteroatom $Ti/WO_6$ having octahedral geometry at the center, and six $WO_6$ octahedrons around the heteroatom $Ti/WO_6$ form a skeleton with edge-sharing of oxygen atoms. FIG. 2 shows a framework in an ab plane, and FIG. 3 shows a framework in an ac plane. $K_6Na_2Ti_{0.92}W_{6.08}O_{24} \cdot 12H_2O$ is confirmed to be planar and have a zero-dimension framework structure, the same as general Anderson-type POM. Generally, an M/X ratio is 6, but the $K_6Na_2Ti_{0.92}W_{6.08}O_{24} \cdot 12H_2O$ according to an exemplary embodiment did not have only $Ti^{4+}$ at a hetero-site but showed occupancy of $Ti^{4+}$ and $W^{4+}$ at about 92% to 8% at the hetero-site. The crystal data of $K_6Na_2Ti_{0.92}W_{6.08}O_{24} \cdot 12H_2O$ is shown in the following Table 2.

(Table 2)

| Empirical formula | $K_6Na_2Ti_{0.92}W_{6.08}O_{24} \cdot 12H_2O$ |
|---|---|
| Formula weight | 2042.78 |
| Crystal system | Trigonal |
| Space group | R -3 m |
| Z | 3 |
| a (Å) | 13.1000 10 |
| b (Å) | 13.1000 10 |
| c (Å) | 18.3313 14 |
| V Å³ | 2724.4 5 |
| Temperature (K) | 173 2 |
| $\rho_{calcd}$ (g cm⁻³) | 3.735 |
| $\mu$ mm⁻¹ | 20.189 |
| R (F)ᵃ | 0.0120 |
| $R_w(F^2_o)$ᵇ | 0.0404 |

In Table 2, R(F) and $R_w$ ($F^2_o$) are calculated by the following Equations 1 and 2.

[Equation 1]

$$R(F) = \sum||F_o|-|F_c|| / \sum|F_o|$$

[Equation 2]

$$R_w (F^2_o) = [\sum w (F^2_o-F^2_c)^2 / \sum w (F^2_o)^2]^{1/2}$$

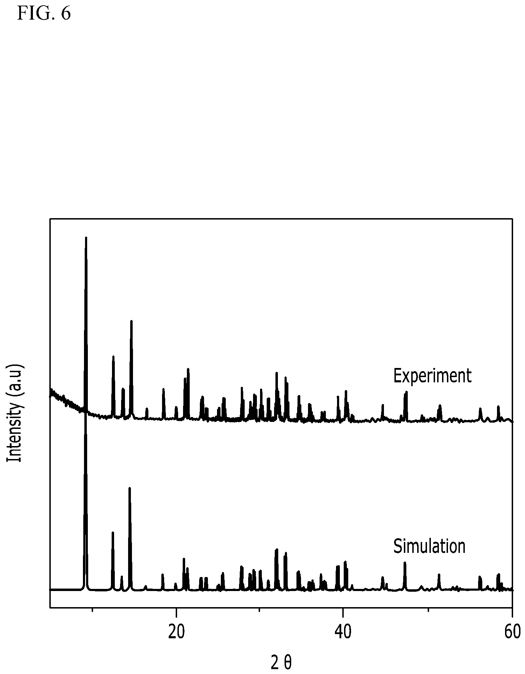

Referring to FIG. 6, the powder XRD pattern of $K_6Na_2Ti_{0.92}W_{6.08}O_{24} \cdot 12H_2O$ which is actually synthesized in Example 1 and the powder XRD pattern simulated based on the refined structure from single crystal XRD are compared, and it is represented that the two patterns match each other.

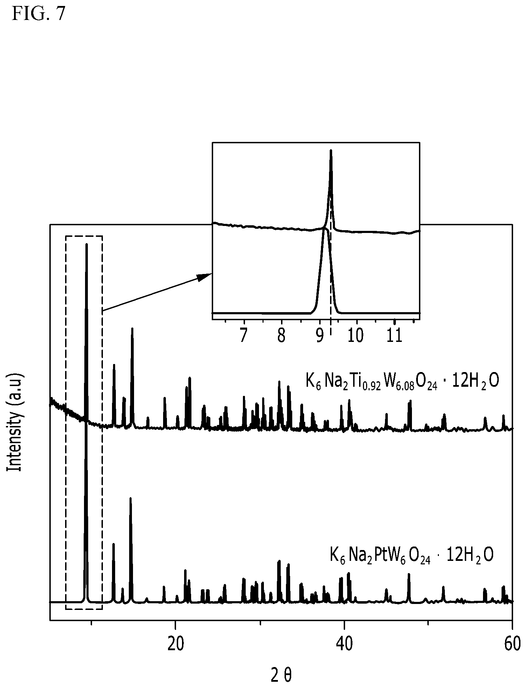

Referring to FIG. 7, $K_6Na_2Ti_{0.92}W_{6.08}O_{24} \cdot 12H_2O$ which is actually synthesized in Example 1 and $K_6Na_2Pt-W_6O_{24} \cdot 12H_2O$ which is conventional Anderson-type POM are compared. The $K_6Na_2Ti_{0.92}W_{6.08}O_{24} \cdot 12H_2O$ which is actually synthesized showed a structurally very similar pattern to $K_6Na_2PtW_6O_{24} \cdot 12H_2O$ (space group R-3m (No. 166)). However, since the elements forming the heteroatom positioned at the center are Ti and Pt, respectively, which are different, the powder pattern shifts to the right on the whole due to a difference in a bond distance between X and O in $XO_6$. The Ti-O bond distance is about 1.970 Å, and a Pt-O bond distance is about 2.013 Å. Accordingly, the lattice parameter of Ti-POM (a = b = 13.1000 Å, c = 18.1333 Å) is smaller than that of the Pt-POM (a = b = 13.1376 Å, c = 18.3504 Å).

In order to confirm that Ti is clearly contained in the Anderson-type polyoxometalate synthesized in Example 1 and also confirm the composition ratio, 10 mg of a synthesized powder sample is completely dissolved in 10 mL of a 0.01 M HCl solution, and the composition ratio is confirmed with Inductively coupled plasma-optical emission spectroscopy (ICP-OES). The results are represented in the following Table 3, and the composition ratio calculated from SC-XRD and the stoichiometric value (W/Ti -6.6) of the experimental value match each other.

(Table 3)

| | Atomic ratio (basis Ti) | |
|---|---|---|
| Element | Calculated composition (SC-XRD) | Experimental composition (ICP-OES) |
| K | 6.5 | 6.7 |

(continued)

| Element | Atomic ratio (basis Ti) | |
| --- | --- | --- |
| | Calculated composition (SC-XRD) | Experimental composition (ICP-OES) |
| Na | 2.2 | 2.4 |
| Ti | 1 | 1 |
| W | 6.6 | 6.6 |

Hereinabove, the preferred exemplary embodiments of the present disclosure have been described in detail, but the scope of rights for the present disclosure is not limited thereto, and various modifications and improved forms by a person skilled in the art using the basic concept of the present disclosure defined in the following claims also belong to the scope of rights for the present disclosure.

**Claims**

1.  An Anderson-type polyoxometalate comprising:
    titanium as a heteroatom at a center of the Anderson-type polyoxometalate.

2.  The Anderson-type polyoxometalate of claim 1, wherein:
    the heteroatom positioned at the center is $Ti/WO_6$ having an octahedral geometry and six $WO_6$ octahedrons around the heteroatom have edge-sharing of oxygen atoms.

3.  The Anderson-type polyoxometalate of claim 2, wherein:
    the Anderson-type polyoxometalate is planar and has a zero-dimension framework structure.

4.  The Anderson-type polyoxometalate of claim 1, wherein:
    the Anderson-type polyoxometalate includes titanium and tungsten, and a molar ratio of a titanium precursor deriving the titanium and a tungsten precursor deriving the tungsten is 0.5:6 to 2.5:6.

5.  An Anderson-type polyoxometalate represented by the following Chemical Formula 1:

    [Chemical Formula 1]          $K_6Na_2Ti_{1-a}W_{6+a}O_{24} \cdot 12H_2O$ (0 < a < 0.2).

6.  The Anderson-type polyoxometalate of claim 5, wherein:
    $Ti^{4+}$ and $W^{4+}$ show occupancy at a ratio of (1-a) to a in a hetero-site of the Anderson-type polyoxometalate.

7.  A method for preparing an Anderson-type polyoxometalate, the method comprising:

    mixing a titanium precursor and a tungsten precursor to prepare a mixture,
    sealing the mixture in a container and heating to form a hydrothermal synthetic solution, and
    cooling the hydrothermal synthetic solution and then adding a solute to form an Anderson-type polyoxometalate.

8.  The method for preparing an Anderson-type polyoxometalate of claim 7, wherein:
    the hydrothermal synthesis is carried out at 20°C to 500°C for 1 day to 3 days.

9.  The method for preparing an Anderson-type polyoxometalate of claim 7, wherein:
    a mixing molar ratio of the titanium precursor and the tungsten precursor is 0.5:6 to 2.5:6.

10.  The method for preparing an Anderson-type polyoxometalate of claim 7, further comprising:
    Washing the formed Anderson-type polyoxometalate with a washing solution, carrying out centrifugation, and then drying to obtain Anderson-type polyoxometalate powder.

11.  The method for preparing an Anderson-type polyoxometalate of claim 7, further comprising:
    filtering the formed Anderson-type polyoxometalate to obtain an Anderson-type polyoxometalate single crystal.

12. A method for preparing an Anderson-type polyoxometalate, the method comprising:

mixing titanium oxysulfate and sodium tungstate to prepare a mixture,
sealing the mixture in a container and heating to form a hydrothermal synthetic solution, and
cooling the hydrothermal synthetic solution and then adding potassium chloride to form an Anderson-type polyoxometalate.

FIG. 1

Ti/WO$_6$ octahedron    +    Six edge-sharing WO$_6$ octahedrons

Legend:
- Ti/W
- W
- K
- Na
- O

FIG. 2

FIG. 3

FIG. 4

Hydrothermal synthesis

$TiOSO_4$
+
$Na_2WO_4$
+
$H_2O$

230 °C, 2 days

Excessive KCl

$K_{10}(H_2W_{12}O_{42})$
+
$K_6Na_2Ti_{0.92}W_{6.08}O_{24}$

Mixing

0.01 M NaOH
Filter

$K_6Na_2Ti_{0.92}W_{6.08}O_{24}$

25 °C, 1 day

Filtrate

FIG. 5

FIG. 6

FIG. 7

# EP 4 520 762 A1

| **INTERNATIONAL SEARCH REPORT** | International application No. |
|---|---|
| | **PCT/KR2023/002470** |

**A. CLASSIFICATION OF SUBJECT MATTER**

**C07F 7/28**(2006.01)i

According to International Patent Classification (IPC) or to both national classification and IPC

**B. FIELDS SEARCHED**

Minimum documentation searched (classification system followed by classification symbols)

C07F 7/28(2006.01); C09D 7/40(2018.01); G11C 16/10(2006.01); G11C 16/34(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 앤더슨형 폴리옥소메탈레이트(anderson-type polyoxometalate), 이종원자 (heteroatom), 티타늄(Ti, titanium)

**C. DOCUMENTS CONSIDERED TO BE RELEVANT**

| Category* | Citation of document, with indication, where appropriate, of the relevant passages | Relevant to claim No. |
|---|---|---|
| X | US 2016-0254058 A1 (THE UNIVERSITY COURT OF THE UNIVERSITY OF GLASGOW) 01 September 2016 (2016-09-01)<br>See claims 27, 29 and 31. | 1 |
| A | | 2-12 |
| A | LIU, C. et al. Construction of two novel titanium oxide clusters: Copper ion introducing enhances photocatalytic performance. European journal of inorganic chemistry. 2020, pp. 4189-4194.<br>See entire document. | 1-12 |
| A | SU, T. et al. Enhanced oxidative desulfurization of fuel in ionic liquid by TiO2 quantum dots catalysts modified with Anderson-type polyoxometalate. Colloids and surfaces A: physicochemical and engineering aspects. online publication date 28 October 2021, vol. 632, article no. 127821, pp. 1-9.<br>See entire document. | 1-12 |
| A | WU, P. et al. Anderson-type polyoxometalates: from structures to functions. Nanoscale. 2021, vol. 13, pp. 7119-7133.<br>See entire document. | 1-12 |

☑ Further documents are listed in the continuation of Box C.     ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **26 May 2023** | **26 May 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2023/002470**

**C.    DOCUMENTS CONSIDERED TO BE RELEVANT**

| Category* | Citation of document, with indication, where appropriate, of the relevant passages | Relevant to claim No. |
|---|---|---|
| A | KR 10-2018-0050030 A (LG CHEM, LTD.) 14 May 2018 (2018-05-14)<br>See entire document. | 1-12 |

Form PCT/ISA/210 (second sheet) (July 2022)

**INTERNATIONAL SEARCH REPORT**
**Information on patent family members**

International application No.

**PCT/KR2023/002470**

| Patent document cited in search report | | | Publication date (day/month/year) | Patent family member(s) | | | Publication date (day/month/year) |
|---|---|---|---|---|---|---|---|
| US | 2016-0254058 | A1 | 01 September 2016 | EP | 3063782 | A1 | 07 September 2016 |
| | | | | US | 9922713 | B2 | 20 March 2018 |
| | | | | WO | 2015-063492 | A1 | 07 May 2015 |
| KR | 10-2018-0050030 | A | 14 May 2018 | CN | 109937239 | A | 25 June 2019 |
| | | | | CN | 109937239 | B | 11 January 2022 |
| | | | | EP | 3536752 | A1 | 11 September 2019 |
| | | | | EP | 3536752 | B1 | 29 December 2021 |
| | | | | JP | 2019-537649 | A | 26 December 2019 |
| | | | | JP | 6852853 | B2 | 31 March 2021 |
| | | | | US | 11390717 | B2 | 19 July 2022 |
| | | | | US | 2019-0276620 | A1 | 12 September 2019 |
| | | | | WO | 2018-084504 | A1 | 11 May 2018 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060108563 A

- US 20190352320 A

**Non-patent literature cited in the description**

- **AMIR BLAZEVIC et al.** *The Anderson-Evans poly-oxometalate: From inorganic building blocks via hybrid organic-inorganic structures to tomorrows "Bio-POM*

- **AMIR BLAZEVIC ; ANNETTE ROMPEL.** *Coordination Chemistry Reviews*, 2016, vol. 307, 42-64